# EUROPÄISCHE PATENTANMELDUNG

(11) **EP 1 326 203 A2**
(43) Veröffentlichungstag der Anmeldung: **09.07.2003**
(21) Anmeldenummer: 02102850.1
(22) Anmeldetag: 20.12.2002
(51) Int. Cl.: G06K 19/073

(54) **Verfahren und Anordnung zum Schutz von digitalen Schaltungsteilen**

(30) Priorität: 29.12.2001 DE 10164419
(71) Anmelder: Philips Intellectual Property & Standards GmbH, 20099 Hamburg (DE); Koninklijke Philips Electronics N.V., 5621 BA Eindhoven (NL)
(72) Erfinder: Feuser, Markus, 52088, Aachen (DE); Malzahn, Ralf, 52088, Aachen (DE)
(74) Vertreter: Volmer, Georg, Dipl.-Ing.

(57) **Zusammenfassung**

Die Erfindung betrifft ein Verfahren und eine Anordnung zum Schutz von digitalen Schaltungsteilen, die insbesondere genutzt werden können, um Speichereinheiten auf solchen digitalen Schaltungen, insbesondere Smartcard-Controllern, die geheime Daten enthalten, gegen Attacken zu schützen, die den Ansatz verfolgen, digitale Schaltungsteile, insbesondere den Digitalteil eines Smartcard-Controllers, durch kurzzeitige Spannungseinbrüche, z.B. durch Lichtblitzattacken, in einen undefinierten Zustand zu versetzen.

## Beschreibung

Die Erfindung betrifft ein Verfahren und eine Anordnung zum Schutz von digitalen Schaltungsteilen, die insbesondere genutzt werden können, um Speichereinheiten auf solchen digitalen Schaltungen, insbesondere Smartcard-Controllern, die geheime Daten enthalten, gegen Attacken zu schützen, die den Ansatz verfolgen, digitale Schaltungsteile, insbesondere den Digitalteil eines Smartcard-Controllers, durch kurzzeitige Spannungseinbrüche, z.B. durch Lichtblitzattacken, in einen undefinierten Zustand zu versetzen.

Die Entwicklung der Mikroelektronik in den 70er Jahren ermöglichte es, kleine Computer im Kreditkartenformat ohne Benutzungsschnittstelle herzustellen. Solche Computer werden als Smartcards bezeichnet. In einer Smartcard sind Datenspeicher und arithmetischlogische Einheiten in einem einzigen Chip von wenigen Quadratmillimetern Größe integriert. Smartcards werden insbesondere als Telefonkarten, GSM-SIM-Karten, im Bankenbereich und im Gesundheitswesen eingesetzt. Die Smartcard ist damit zur allgegenwärtigen Rechenplattform geworden.

Smartcards werden derzeit vornehmlich als sicherer Aufbewahrungsort für geheime Daten und als sichere Ausführungsplattform für kryptographische Algorithmen betrachtet. Die Annahme einer relativ hohen Sicherheit der Daten und Algorithmen auf der Karte liegt im Hardwareaufbau der Karte und den nach außen geführten Schnittstellen begründet. Die Karte stellt sich nach außen als "Black Box" dar, deren Funktionalität nur über eine wohldefinierte Hardware- und Softwareschnittstelle in Anspruch genommen werden kann und die bestimmte Sicherheitspolicies erzwingen kann. Zum einen kann der Zugriff auf Daten an bestimmte Bedingungen geknüpft werden. Kritische Daten, wie z.B. geheime Schlüssel eines Public-Key-Verfahrens, können dem Zugriff von außen sogar völlig entzogen werden. Zum anderen ist eine Smartcard in der Lage, Algorithmen auszuführen, ohne dass die Ausführung der einzelnen Operationen von außen beobachtet werden kann. Die Algorithmen selbst können auf der Karte vor Veränderung und Auslesen geschützt werden. Im objektorientierten Sinn läßt sich die Smartcard als abstrakter Datentyp auffassen, der über eine wohldefinierte Schnittstelle verfügt, ein spezifiziertes Verhalten aufweist und selbst in der Lage ist, die Einhaltung bestimmter Integritätsbedingungen bezüglich seines Zustandes sicherzustellen.

Es gibt im Wesentlichen zwei verschiedene Typen von Smartcards. Speicherkarten besitzen lediglich eine serielle Schnittstelle, eine Adressierungs- und Sicherheitslogik und ROMund EEPROM-Speicher. Diese Karten besitzen nur eingeschränkte Funktionalität und dienen einer spezifischen Anwendung. Dafür sind sie besonders billig herzustellen. Als Mikroprozessorkarten hergestellte Smartcards stellen im Prinzip einen vollständigen Universalrechner dar.

Der Herstellungs- und Auslieferungsprozeß für Chipkarten gliedert sich in folgende Phasen:
- Herstellen des Halbleiters,
- Einbetten des Halbleiters,
- Bedrucken der Karte,
- Personalisierung der Karte,
- Ausgeben der Karte.

Im Allgemeinen wird jede Phase von einer auf die jeweilige Arbeit spezialisierten Firma durchgeführt. Beim Herstellen der Halbleiter ist insbesondere bei Karten mit fest verdrahteter Sicherheitslogik auf eine gute betriebsinterne Sicherheit zu achten. Damit vom Hersteller ein korrekter Endtest durchgeführt werden kann, muß der komplette Speicher frei zugänglich sein. Erst nach dem Endtest wird der Chip durch einen Transportcode gesichert. Danach ist der Zugriff auf den Kartenspeicher nur für berechtigte Stellen, die den Transportcode kennen, möglich. Ein Diebstahl fabrikneuer Halbleiter bleibt damit ohne Folgen. Berechtigte Stellen können Personalisierer bzw. Kartenausgeber sein. Für das Einbetten und Bedrucken sind keine weiteren Sicherungsfunktionen notwendig. Die betreffenden Firmen brauchen den Transportcode nicht zu kennen.

Im Allgemeinen überträgt nicht der Kartenhersteller, sondern die ausgebende Stelle (z.B. Bank, Telefongesellschaft, Krankenkasse etc.) die personenspezifischen Daten in die Karte. Diesen Vorgang nennt man Personalisierung. Für sie ist die Kenntnis des Transportcodes notwendig.

Das Ausgeben der Karte, also der Transport von der ausgebenden Stelle zum Karteninhaber, stellt ein weiteres Sicherheitsproblem dar. Genau genommen ist nur die persönliche Ausgabe an den Karteninhaber gegen Unterschrift und Vorlage des Personalausweises sicher. Ein Versand per Post ist zwar oft wirtschaftlicher, aber auch ziemlich unsicher. Ein Problem ist auch das Übermitteln der PIN an den Karteninhaber, hier muß die gleiche Sorgfalt wie für die Karte gelten.

Bedingt durch die brisanten, sicherheitsrelevanten Inhalte der auf Smartcard-Controllern befindlichen Speicher ist neben der Beachtung dieser Sicherungsmaßnahmen ein zusätzlicher Schutz gegen mögliche Aktivitäten von Hackern zu gewährleisten, die sich auf alle Phasen des Lebenslaufes einer Smartcard - beginnend von der Herstellung, über Transport, Nutzung der Karte bis zu Manipulationen unbrauchbar gewordener Karten - erstrecken.

Das größte Augenmerk beim Schutz gegen ein Ausspähen von Daten und Programmen auf Datenträgern, z.B. Chips auf Chipkarten, gilt der Verschlüsselung dieser Daten; eine Sicherung gegen unerlaubten Zugriff zum Chip ist minimal oder nicht gegeben; bei einer Chipkarte ist ein mechanischer Zugriff auf die Daten bzw. deren Entnahme meist nach chemischer Entfernung der Kunststoffschicht mit einer durch eine vorhandene Passivierungsabdeckung des Chips durchgestochenen Tastnadel möglich. Einige Hacker-Attacken verfolgen auch den Ansatz, den Digitalteil eines Smartcard-Controllers in einen undefinierten Zustand zu bringen. Hierbei werden kurzzeitige Spannungseinbrüche z.B. durch Lichtblitzattacken provoziert.

In der WO 98/18102 ist ein Verfahren und eine Anordnung zum Schutz von elektronischen Recheneinheiten gegen unerwünschten Zugriff beschrieben. Dabei wird die einem Angriff ausgesetzte Seite der Recheneinheit mit einer Ummantelung mit inhomogenen Eigenschaften versehen. Von der Recheneinheit werden an einer oder mehreren Meßstellen der Ummantelung Meßwerte ermittelt, nachdem an einer festgelegten Signalaufgabestelle der Ummantelung von der Recheneinheit definierte Signale angelegt wurden. Mit den dabei aufgenommenen Meßwerten wird eine Signatur gebildet und in einem Register abgelegt. Da jede Verletzung bzw. Beschädigung die speziellen Eigenschaften der Ummantelung verändern, ergibt der nach einer Verletzung aufgenommene Meßwert eine andere Signatur, als im Register für die unversehrte Ummantelung abgelegt ist. Ein Vergleich der Signaturen führt in diesem Fall zu einer Fehlermeldung und zu weiteren für einen solchen Fall vorgesehenen Schritten.

Eine Methode, um unbefugtes Ausführen von sicherheitsrelevanten Programmen, z.B. in Smartcards, zu verhindern, wird in der US-Patentschrift 5,682,031 beschrieben. Bei Anwendung der Methode werden von einem in den EPROM der Smartcard eingeschriebenen logischen Riegel (lock) mehrere Kopien erzeugt, welche an unterschiedlichen Speicherorten im EPROM abgelegt und durch eine ODER-Logik verknüpft werden. Eine Sicherung nach dieser Methode verhindert zwar die unbefugte Ausführung der so geschützten sicherheitsrelevanten Programme, wenn sie blockiert werden. Allerdings wird damit nicht garantiert, dass dieser Schutz wirksam ist, wenn sich der Smartcard-Controller in einem undefinierten Zustand befindet.

Die US 5,465,349 beschreibt ein Sicherungsverfahren zur Überwachung von integrierten Schaltkreisen auf undefinierte Zustände; dazu erfolgt erstens vor jeder Datenübertragung an ein externes Gerät und zweitens vor jeder Änderung (Schreiben bzw. Löschen) von Speicherdaten des integrierten Schaltkreises, die in der Regel in einem EPROM oder EEPROM abgelegt sind, eine Statusabfrage eines oder mehrerer Sicherheitsregister. Der Status der Sicherheitsregister wird verändert, wenn das System einen nicht definierten Zustand feststellt, wobei zu diesem Zweck auch Sensoren, z.B. ein Sensor, welcher die Arbeitsfrequenz des Schaltkreises überwacht, oder ein optischer Sensor, eingesetzt werden können.

In der US-Patentschrift US 6,092,147 wird eine verteilte Überprüfung von hardwareunabhängigem, ausführbarem Bytecode beschrieben, der von einer Rechenanlage an eine virtuelle Maschine übertragen wird, um dort ausgeführt zu werden. Bei der Prüfung wird der Bytecode mit vorgegebenen Kriterien verglichen; dabei erfolgt die Prüfung folgenderweise. Nach abgeschlossener Prüfung auf der sendenden Rechenanlage wird das Prüfergebnis von der virtuellen Maschine erst bestätigt, bevor der Bytecode auf der virtuellen Maschine ausgeführt wird.

Mit einer in der US-Patentschrift 6,249,872 angegebenen Methode wird der Schutz gegen unerlaubten Zugriff auf geschützte Speicher eines elektronischen Systems, insbesondere eines Computersystems, verbessert, indem folgende Schritte ausgeführt werden: Setzen des Computersystems in eine Betriebsart, in der ein Bestätigungsprozeß durchgeführt wird; anschließend wird vor Verlassen dieser Betriebsart ein Sicherheits-Schaltkreis in einen ersten vorgegebenen Status versetzt; anschließend erfolgt eine Prüfung des Status des Sicherheits-Schaltkreises, wobei die von dem Computersystem ausgeführten Operationen gestoppt werden, wenn sich der Sicherheits-Schaltkreis in einem anderen als dem vorgegebenen Status befindet.

Die sich auf Smartcard-Controllern befindende Sensorik basiert üblicherweise aufAnalogschaltungstechnik. Diese analog ausgeführten Schaltungsteile (z.B. Spannungs-, Licht-, Temperatur- und Lichtsensoren) müssen heute von der sog. Glue-Logic getrennt gehalten werden. Die Gründe dafür sind:
- Störungsempfindlichkeit ― Eng benachbarte digitale Schaltungsteile stören die empfindliche Sensorik.
- Schaltungselemente ― In analogen Schaltungen werden nicht nur die NMOS- und PMOS-Standardtransistoren verwendet, sondern auch speziell dimensionierte Transistoren, Kondensatoren und Widerstände. Diese passen aufgrund ihrer Größe nicht in das vorgegebene Raster der Standardzellen.

Die Folge davon ist, dass Spezialisten die Sensorik lokalisieren können. Darüber hinaus ist es mit speziellen Geräten (z.B. mit Focus Ion Beam, FIB) möglich, die bereits lokalisierte Sensorik auszuschalten.

Natürlich können sensible Schaltungsteile mittels speziellem Layout geschützt werden, dies bedeutet aber einen hohen Aufwand, der heute bei Smartcard-Controllern üblich ist. Zum Teil kann ein erfahrener Hacker trotzdem Manipulationen vornehmen.

Der Erfindung liegt deshalb die Aufgabe zugrunde, ein Verfahren und eine Anordnung der gattungsgemäßen Art anzugeben, durch welche die Nachteile der herkömmlichen Schutzmaßnamen behoben werden und insbesondere verhindert wird, dass geheime, in einem digitalen Schaltungsteil gespeicherte Daten zugänglich werden, nachdem es gelungen ist, diesen digitalen Schaltungsteil in einen undefinierten Zustand zu bringen.

Erfindungsgemäß wird diese Aufgabe gelöst durch die Merkmale im kennzeichnenden Teil der Ansprüche 1 und 6 im Zusammenwirken mit den Merkmalen im Oberbegriff. Zweckmäßige Ausgestaltungen der Erfindung sind in den Unteransprüchen enthalten.

Ein besonderer Vorteil des Verfahrens zum Schutz von digitalen Schaltungsteilen besteht darin, dass Spannungseinbrüche detektiert werden.

Eine Anordnung zum Schutz von digitalen Schaltungsteilen ist vorteilhaft so aufgebaut, dass der digitale Schaltungsteil (Glue-Logic) mindestens einen digitalen Sensor 1 umfaßt.

Ein weiterer Vorteil des erfindungsgemäßen Verfahrens besteht darin, dass die Spannungseinbrüche innerhalb der Glue-Logic detektiert werden. Insbesondere ist das erfindungsgemäße Verfahren einsetzbar, um Spannungseinbrüche innerhalb eines Smartcard-Controllers zu detektieren.

In einer weiteren bevorzugter Anwendung des erfindungsgemäßen Verfahrens ist vorgesehen, dass die Spannungseinbrüche durch digitale Sensoren detektiert werden.

Als vorteilhaft erweist es sich außerdem, wenn bei dem erfindungsgemäßen Verfahren, die Sensoren aktiviert werden, indem das Reset-Signal auf logisch Null gesetzt wird.

In bevorzugter Ausführung der erfindungsgemäßen Anordnung ist vorgesehen, dass beim Vorhandensein mehrerer Sensoren diese mit einer ODER-Schaltung verknüpft sind.

Eine weitere bevorzugter Ausführung der erfindungsgemäßen Anordnung ist dadurch ausgezeichnet, dass der (die) Sensor(en) als spezielle Standardzelle ausgebildet ist (sind), welche ein NOR-Gatter, einen Inverter und einen Kondensator umfaßt.

Vorteilhaft ist es auch, dass NOR-Gatter und Inverter als Latch geschaltet sind. Darüber hinaus ist in bevorzugter Ausgestaltung der Erfindung vorgesehen, dass die Standardzelle(n) ein NOR-Gatter sowie einen Inverter aufweist (aufweisen), wobei der Eingang des NOR-Gatters mit dem Ausgang des Inverters sowie über einen Kondensator mit der Versorgungsspannung verbunden ist und der Eingang des Inverters mit dem Ausgang des NOR-Gatters verbunden ist und am Eingang des NOR-Gatters das Reset-Signal anlegbar und am Ausgang des NOR-Gatters das Fehlersignal abgreifbar ist.

Ebenso erweist es sich als Vorteil, dass die Schwellenspannung der in dem NOR-Gatter und dem Inverter verwendeten Transistoren unterschiedlich ausgelegt sind. Ein weiterer Vorteil besteht darin, dass der (die) Sensor(en) als Licht- oder Spannungssensor ausgebildet ist (sind). In einer bevorzugten Ausgestaltung der erfindungsgemäßen Anordnung ist vorgesehen, dass die sog. Glue-Logic Bestandteil eines Smartcard-Controllers ist.

Eine spezielle Sensorik, über den Digitalteil (Glue-Logic) verteilt, schützt gegen die genannten Attacken. Dadurch, dass sich die Sensoren innerhalb der Glue-Logic befinden, wird folgender Vorteil erlangt. Die Sensoren können erstens Spannungseinbrüche dort erkennen, wo sie am kritischsten sind. Zweitens sind die Sensoren nicht mehr als solche erkennbar.

Die Sicherheit des gesamten Chips wird deutlich erhöht. Attacken auf die Glue-Logic selbst, z.B. durch Lichtblitzattacken, werden direkt vor Ort erkannt. Weiter sind die Sensoren sehr klein, wodurch eine höhere Anzahl von Instanzen auf der Glue-logic verteilt werden kann, ohne viel Chipfläche zu verlieren. Die Sensoren sind als solche nicht erkennbar oder von den Standardzellen zu unterscheiden.

Die Erfindung wird nachfolgend in einem Ausführungsbeispiel anhand der zugehörigen Zeichnungen näher erläutert. Es zeigen:
- Fig. 1: eine Verteilung der speziellen Standardzellen als Sensoren in einem Digitalteil,
- Fig. 2: einen Aufbau eines als Standardzelle aufgebauten Sensors.

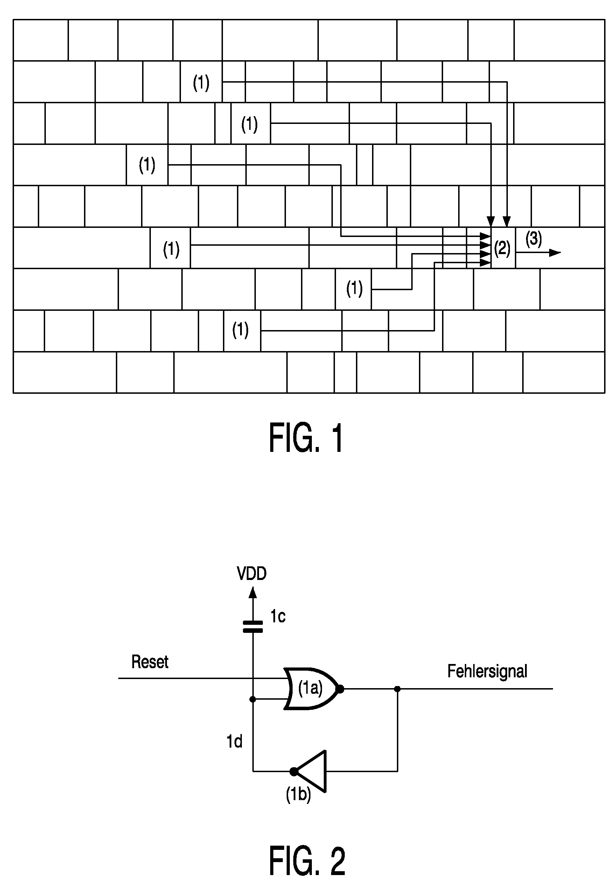

Im Folgenden wird der Digitalteil nach Fig. 1 vorgestellt. Die Ausgangssignale als Sensor arbeitender Standardzellen 1 werden mit einer ODER-Schaltung 2 miteinander verknüpft. Ein endgültiges Ausgangssignal 3 der ODER-Schaltung 2 ist dann aktiv, wenn einer oder mehrere Sensoren 1 ein Fehlersignal liefern.
Die in Fig. 2 gezeigte, beispielhafte Anordnung eines als Standardzelle aufgebauten Sensors 1 umfaßt ein NOR-Gatter 1a und einen Inverter 1b; diese arbeiten als Latch. Ein Knoten 1d, in dem ein Eingang des NOR-Gatters 1a mit dem Ausgang des Inverters 1b verbunden ist, ist über einen Kondensator 1c mit einer Versorgungsspannung VDD verbunden. Der Eingang des Inverters 1b ist mit dem Ausgang des NOR-Gatters 1a verbunden. An einem weiteren Eingang des NOR-Gatters 1a ist ein Reset-Signal anlegbar und am Ausgang des NOR-Gatters 1a ist das von diesem Sensor 1 zu liefernde Fehlersignal abgreifbar.

Das das NOR-Gatter 1a und den Inverter 1b umfassende Latch kann mittels des Reset-Signals so zurückgesetzt werden, dass das vom Sensor 1 abgegebene Fehlersignal inaktiv wird und den Zustand logisch "0" annimmt. Der Knoten 1d ist in diesem Zustand logisch "1".

Sobald das Reset-Signal auf logisch "0" wechselt, ist der Sensor 1 "scharf". Spannungseinbrüche an der Versorgungsspannung VDD passieren den Kondensator 1c, so dass am Knoten 1d ein kurzer Spannungseinbruch ankommt. Aufgrund einer speziellen Eigenschaft des Latches, bestehend aus 1a und 1b, führt dieser Spannungseinbruch zum Kippen des Latches, das Fehlersignal wechselt auf logisch "1". Dieser Zustand bleibt bis zum nächsten Reset-Puls gespeichert.

Die oben genannte spezielle Eigenschaft ist z.B. durch Asymmetrie gegeben, indem man die Schwellenspannungen der in den Gattern 1a und 1b verwendeten Transistoren unterschiedlich auslegt. Hierdurch erhält das Latch eine Vorzugsrichtung, die dem Fehlerzustand entspricht.

Die Erfindung ist nicht beschränkt auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung zu verlassen.

### BEZUGSZEICHENLISTE

- 1: als Sensor arbeitende Standardzelle
- 1a: NOR-Gatter
- 1b: Inverter
- 1c: Kondensator
- 1d: Knoten
- 2: ODER-Schaltung
- 3: Ausgangssignal

## Patentansprüche

1. Verfahren zum Schutz von digitalen Schaltungsteilen,
**dadurch gekennzeichnet,**
**dass** Spannungseinbrüche detektiert werden.

2. Verfahren nach Anspruch 1,
**dadurch gekennzeichnet,**
**dass** die Spannungseinbrüche innerhalb wenigstens eines der (als "Glue-Logic" bezeichneten) digitalen Schaltungsteile detektiert werden.

3. Verfahren nach einem der vorhergehenden Ansprüche,
**dadurch gekennzeichnet,**
**dass** die Spannungseinbrüche innerhalb eines Smartcard-Controllers detektiert werden.

4. Verfahren nach einem der vorhergehenden Ansprüche,
**dadurch gekennzeichnet,**
**dass** die Spannungseinbrüche durch digitale Sensoren detektiert werden.

5. Verfahren nach einem der vorhergehenden Ansprüche,
**dadurch gekennzeichnet,**
**dass** die Sensoren aktiviert werden, indem das Reset-Signal auf logisch Null gesetzt wird.

6. Anordnung zum Schutz von digitalen Schaltungsteilen
**dadurch gekennzeichnet,**
**dass** der digitale Schaltungsteil (Glue-Logic) mindestens einen digitalen Sensor (1) umfaßt.

7. Anordnung nach Anspruch 6,
**dadurch gekennzeichnet,**
**dass** beim Vorhandensein mehrerer Sensoren (1) diese mit einer ODER-Schaltung (2) verknüpft sind.

8. Anordnung nach einem der Ansprüche 6 oder 7,
**dadurch gekennzeichnet, dass** der (die) Sensor(en) (1) als spezielle Standardzelle ausgebildet ist (sind), welche ein NOR-Gatter (1a), einen Inverter (1b) und einen Kondensator (1c) umfaßt.

9. Anordnung nach Anspruch 8,
**dadurch gekennzeichnet,**
**dass** NOR-Gatter (1a) und Inverter (1b) als Latch geschaltet sind.

10. Anordnung nach Anspruch 8,
**dadurch gekennzeichnet,**
**dass** die Standardzelle(n) (1) ein NOR-Gatter (1a) sowie einen Inverter (1b) aufweist (aufweisen), wobei ein Eingang des NOR-Gatters (1a) mit dem Ausgang des Inverters (1b) sowie über einen Kondensator (1c) mit einer Versorgungsspannung (VDD) verbunden ist und der Eingang des Inverters (1b) mit dem Ausgang des NOR-Gatters (1a) verbunden ist und an einem weiteren Eingang des NOR-Gatters (1a) das Reset-Signal anlegbar und am Ausgang des NOR-Gatters (1a) ein Fehlersignal abgreifbar ist.

11. Anordnung nach einem der Ansprüche 8 bis 10,
**dadurch gekennzeichnet,**
**dass** Schwellenspannungen im NOR-Gatter (1a) und im Inverter (1b) verwendeter Transistoren unterschiedlich ausgelegt sind.

12. Anordnung nach einem der Ansprüche 6 bis 11,
**dadurch gekennzeichnet,**
**dass** der (die) Sensor(en) (1) als Licht- oder Spannungssensor ausgebildet ist (sind).

13. Anordnung nach einem der Ansprüche 6 bis 12,
**dadurch gekennzeichnet,**
**dass** die "Glue-Logic" Bestandteil eines Smartcard-Controllers ist.
